# EUROPEAN PATENT APPLICATION

(11) **EP 4 773 462 A1**
(43) Date of publication of application: **08.07.2026**
(21) Application number: 24892965.5
(22) Date of filing: 30.08.2024
(51) Int. Cl.: H02J 7/00

(54) **ENERGY STORAGE APPARATUS AND ENERGY STORAGE VALVE TOWER**

(30) Priority: 22.11.2023 CN 202323168063 U
(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: LI, Huajun, Shanghai 200241 (CN); GUO, Zide, Shanghai 200241 (CN); MAO, Zhiyun, Shanghai 200241 (CN); LUO, Bingtuan, Shanghai 200241 (CN); LU, Yanhua, Shanghai 200241 (CN); YU, Dongxu, Shanghai 200241 (CN)
(74) Representative: Gong, Jinping
(86) International application number: PCT/CN2024/116135
(87) International publication number: WO 2025/107806

(57) **Abstract**

The present application provides an energy storage device (100) and an energy storage valve tower (1000). The energy storage device (100) includes an electrical cabinet module (10), a power module (20), and a bus module (30). The power module (20) and the bus module (30) are detachably connected to an electrical cabinet frame (11) of the electrical cabinet module (10). The energy storage device (100) provided in embodiments of the present application allows the power module (20) and the bus module (30) to be removed from the electrical cabinet frame (11) of the electrical cabinet module (10) when transportation is required, enabling separate packaging and transportation of the power module (20), bus module (30), and electrical cabinet module (10). As compared to integral transportation, the power module (20), bus module (30), and electrical cabinet module (10) as separate modules are lighter in weight than the complete energy storage device (100) and can be transported separately, thereby effectively improving transportation convenience.

## Description

The present application claims priority to Chinese Patent Application No. 202323168063.1, filed on November 22, 2023, and entitled "ENERGY STORAGE DEVICE AND ENERGY STORAGE VALVE TOWER," which is incorporated herein by reference in its entirety.

### TECHNICAL FIELD

The present application relates to the technical field of energy storage structures, and in particular provides an energy storage device and an energy storage valve tower.

### BACKGROUND

With the rapid development of new energy technologies, the application of high-power electronic devices is becoming increasingly widespread. For such devices, a large number of modules and various components are provided inside, resulting in a large volume and heavy weight, which makes transportation difficult.

### SUMMARY

An objective of embodiments of the present application is to provide an energy storage device and an energy storage valve tower, aiming to address the issue in the related art that the energy storage device is large in volume and heavy in weight, which makes transportation difficult.

To achieve the above objective, the technical solution adopted by the embodiments of the present application is as follows.

In a first aspect, embodiments of the present application provide an energy storage device, including an electrical cabinet module, a power module, and a bus module. The electrical cabinet module includes an electrical cabinet frame and an electrical cabinet unit disposed within the electrical cabinet frame. The electrical cabinet unit includes a cabinet structure and a battery disposed within the cabinet structure. The power module and the bus module are detachably connected to the electrical cabinet frame.

Beneficial effects of the embodiments of the present application: In the energy storage device provided in these embodiments of the present application, the power module and the bus module are detachably connected to the electrical cabinet frame, which allows the power module and the bus module to be removed from the electrical cabinet frame of the electrical cabinet module when transportation is required, enabling separate packaging and transportation of the power module, bus module, and electrical cabinet module. As compared to integral transportation, the power module, bus module, and electrical cabinet module as separate modules are lighter in weight than the complete energy storage device and can be transported separately, thereby effectively improving transportation convenience.

In some embodiments, the power module and the bus module are detachably connected to an outer side of the electrical cabinet frame.

By adopting the above technical solution, the electrical cabinet unit is accommodated inside the electrical cabinet frame, and the power module and the bus module are externally mounted outside the electrical cabinet frame. In this mounting arrangement, the power module, bus module, and an electrical cabinet unit, which differ significantly in size, can be disposed separately. The electrical cabinet frame is used solely to accommodate the electrical cabinet unit, thereby achieving high space utilization within the electrical cabinet frame and a more compact arrangement of the electrical cabinet units, effectively reducing the overall volume of the electrical cabinet frame. In addition, the power module and the bus module externally mounted outside the electrical cabinet frame enhances the convenience of maintenance operations for the power module and the bus module. In addition, after the power module and bus module are separated from the electrical cabinet frame, their volume is smaller compared to the complete energy storage device, further improving transportation convenience.

In some embodiments, the energy storage device further includes an external mounting frame, the external mounting frame being detachably connected to an outer side of the electrical cabinet frame, with the power module and the bus module accommodated within the external mounting frame.

By adopting the above technical solution, the external mounting frame is utilized to accommodate the power module and the bus module, so that the power module and the bus module can be removed simultaneously by removing the external mounting frame from the cabinet frame, improving the removal and mounting efficiency while enhancing the regularity of the power module and bus module when assembled onto the electrical cabinet module.

In some embodiments, the external mounting frame includes a first frame portion and a second frame portion arranged along the direction of gravity, with the power module accommodated in the first frame portion and the bus module accommodated in the second frame portion.

By adopting the above technical solution, the power module and the bus module are accommodated in the first frame portion and the second frame portion, respectively, enabling the power module and the bus module to be disposed sequentially along the direction of gravity, thereby facilitating separate maintenance operations for the power module and the bus module.

In some embodiments, the energy storage device further includes a limiting apparatus, the limiting apparatus being disposed on the electrical cabinet frame and connected to the external mounting frame.

By adopting the above technical solution, the limiting apparatus is utilized to support and position the external mounting frame, such that the external mounting frame is not only connected to the electrical cabinet frame but also supported and limited by the limiting apparatus, effectively improving the mounting stability of the external mounting frame.

In some embodiments, the limiting apparatus includes a top limiting structure and a bottom limiting structure, both of which are connected to the electrical cabinet frame. In the direction of gravity, the top limiting structure abuts against a top end of the external mounting frame, and the bottom limiting structure abuts against a bottom end of the external mounting frame.

By adopting the above technical solution, the top limiting structure and the bottom limiting structure are utilized to act together on the top and bottom ends of the external mounting frame, thereby supporting and limiting the external mounting frame in the direction of gravity, effectively improving the mounting accuracy of the external mounting frame and improving the stability of the mounted external mounting frame.

In some embodiments, the electrical cabinet units are sequentially disposed along a first direction perpendicular to the direction of gravity, and the external mounting frame is disposed on any side of the electrical cabinet frame in the first direction.

By adopting the above technical solution, the electrical cabinet units may be sequentially disposed within the electrical cabinet frame along the first direction, with the external mounting frame disposed on any side of the electrical cabinet frame in the first direction, so that the external mounting frame avoids the electrical cabinet units in a direction perpendicular to the first direction, facilitating operations on the electrical cabinet units.

In some embodiments, the electrical cabinet units are arranged along the first direction to form a first electrical cabinet group and a second electrical cabinet group, and the first electrical cabinet group and the second electrical cabinet group are arranged along a second direction to form two rows, with cabinet doors of the first electrical cabinet group and the second electrical cabinet group arranged back-to-back; where the second direction is perpendicular to both the direction of gravity and the first direction.

By adopting the above technical solution, the electrical cabinet units are arranged along the first direction to form the first electrical cabinet group and the second electrical cabinet group, with the cabinet doors of the first electrical cabinet group and the second electrical cabinet group arranged back-to-back, thereby increasing the energy density of the energy storage device and allowing operations and maintenance to be performed facing the cabinet doors of the first electrical cabinet group and the cabinet doors of the second electrical cabinet group outside the electrical cabinet frame, effectively improving operational convenience.

In some embodiments, the energy storage device includes a first inlet pipe, a first outlet pipe, a second inlet pipe, and a second outlet pipe. The first inlet pipe and the first outlet pipe are both in communication with the first electrical cabinet group and disposed along the first direction; and the second inlet pipe and the second outlet pipe are both in communication with the second electrical cabinet group and disposed along the first direction.

By adopting the above technical solution, the first inlet pipe and the first outlet pipe may be utilized to circulate cooling medium into the first electrical cabinet group for cooling. The first inlet pipe and the first outlet pipe are disposed along the first direction, that is, their layout direction is the same as the arrangement direction of the first cabinet group, which can effectively improve the regularity and compactness of the arrangement of the first inlet pipe and the first outlet pipe, thereby enhancing the space utilization of the energy storage device. Similarly, the second inlet pipe and the second outlet pipe are respectively disposed along the first direction, which can also improve the regularity and compactness of the arrangement of the second inlet pipe and the second outlet pipe and enhance the space utilization of the energy storage device.

In some embodiments, the energy storage device further includes a third inlet pipe, a third outlet pipe, a fourth inlet pipe, and a fourth outlet pipe. The first inlet pipe is connected to the third inlet pipe, the first outlet pipe is connected to the third outlet pipe, the third inlet pipe and the third outlet pipe are disposed on a side of the external mounting frame that is in the second direction and faces the first electrical cabinet group, and the third inlet pipe and the third outlet pipe are located between the external mounting frame and the electrical cabinet frame. The second inlet pipe is connected to the fourth inlet pipe, the second outlet pipe is connected to the fourth outlet pipe, the fourth inlet pipe and the fourth outlet pipe are disposed on a side of the external mounting frame that is in the second direction and faces the second electrical cabinet group, and the fourth inlet pipe and the fourth outlet pipe are located between the external mounting frame and the electrical cabinet frame.

By adopting the above technical solution, the third inlet pipe and the third outlet pipe are respectively in communication with the first inlet pipe and the first outlet pipe to allow the cooling medium to flow in from the first inlet pipe and out from the first outlet pipe. The placement of the first inlet pipe and the first outlet pipe between the external mounting frame and the electrical cabinet frame can enhance the compactness of the arrangement of the first inlet pipe and the first outlet pipe, reducing their spatial occupation and improving the space utilization of the energy storage device, thereby reducing the spatial footprint of the energy storage device.

In some embodiments, the third inlet pipe and the third outlet pipe are both in communication with the power module.

By adopting the above technical solution, the third inlet pipe and the third outlet pipe located on a side of the external mounting frame can directly communicate with the power module to achieve the purpose of cooling the power module.

In some embodiments, the power module is provided with an inlet busbar and an outlet busbar, the inlet busbar and the outlet busbar being disposed on any side of the external mounting frame in the second direction and located between the external mounting frame and the electrical cabinet frame.

By adopting the above technical solution, the inlet busbar and the outlet busbar are disposed between the external mounting frame and the electrical cabinet frame, so that, in connecting to the inlet busbar and the outlet busbar, a wiring busbar is to be routed between the external mounting frame and the electrical cabinet frame, thereby improving the compactness of the wiring layout and enhancing the space utilization of the energy storage device.

In some embodiments, the energy storage device further includes a shielding cover, the shielding cover being disposed on the electrical cabinet frame and the external mounting frame, and configured to cover at least part of the electrical cabinet frame and at least part of the external mounting frame.

By adopting the above technical solution, the shielding cover can provide equipotential protection for the electrical cabinet frame and the external mounting frame, reducing the likelihood of tip discharge.

In a second aspect, embodiments of the present application further provide an energy storage valve tower, including the energy storage device as described above.

Beneficial effects of the embodiments of the present application: The energy storage valve tower provided in the embodiments of the present application includes the above-described energy storage device, making the transportation and assembly operations of the energy storage valve tower more convenient due to the enhanced transportability of the energy storage device.

In some embodiments, the energy storage devices are stacked along the direction of gravity.

By adopting the above technical solution, the energy storage devices can be stacked along the direction of gravity for assembly, effectively reducing the footprint of the energy storage valve tower.

### DESCRIPTION OF DRAWINGS

To more clearly illustrate the technical solutions in the embodiments of the present application, the drawings required for the description of the embodiments or related art are briefly introduced below. Obviously, the drawings described below are only some embodiments of the present application, and those of ordinary skill in the art can obtain other drawings based on these drawings without creative effort.
FIG. 1 is a schematic structural diagram of an energy storage valve tower according to an embodiment of the present application;
FIG. 2 is a schematic structural diagram of a pipeline and busbar layout of an energy storage valve tower according to an embodiment of the present application;
FIG. 3 is a schematic structural diagram of an energy storage device according to an embodiment of the present application;
FIG. 4 is a schematic structural diagram of an electrical cabinet module according to an embodiment of the present application; and
FIG. 5 is a schematic structural diagram of a bus module and a power module according to an embodiment of the present application.

Reference signs in the figures:
1000. energy storage valve tower; 100. energy storage device; 200. insulation structure; 300. insulation base;
10. electrical cabinet module; 11. electrical cabinet frame; 12. electrical cabinet unit; 121. first electrical cabinet group; 122. second electrical cabinet group;
20. power module; 21. inlet busbar; 22. outlet busbar; 30. bus module;
40. external mounting frame; 41. first frame portion; 42. second frame portion;
50. limiting apparatus; 51. top limiting structure; 52. bottom limiting structure;
61. first inlet pipe; 62. second inlet pipe; 63. third inlet pipe; 64. fourth inlet pipe;
71. first outlet pipe; 72. second outlet pipe; 73. third outlet pipe; 74. fourth outlet pipe;
80. shielding cover;
A. first direction; B. second direction; and G. direction of gravity.

### DESCRIPTION OF EMBODIMENTS

The embodiments of the present application are described in detail below, with examples of the embodiments illustrated in the drawings, where the same or similar reference signs indicate the same or similar elements or elements with the same or similar functions throughout. The embodiments described below with reference to the drawings are exemplary and intended to explain the present application, and should not be construed as limiting the present application.

In the description of the present application, it should be understood that terms such as "length," "width," "up," "down," "front," "rear," "left," "right," "vertical," "horizontal," "top," "bottom," "inner," and "outer" indicating orientation or positional relationships are based on the orientation or positional relationships shown in the drawings, and are used only for convenience in describing the present application and simplifying the description, rather than indicating or implying that the device or element referred to must have a specific orientation, be constructed, or operate in a specific orientation, and therefore should not be construed as limiting the present application.

Furthermore, the terms "first" and "second" are used for descriptive purposes only and should not be understood as indicating or implying relative importance or implicitly indicating the number of technical features indicated. Thus, a feature defined as "first" or "second" may explicitly or implicitly include one or more of such features. In the description of the present application, "multiple" means two or more, unless explicitly and specifically defined otherwise.

In the present application, unless otherwise expressly specified and defined, terms such as "mount," "connect," "connection," and "fix" should be understood broadly. For example, it may refer to a fixed connection, a detachable connection, or an integral connection; it may refer to a mechanical connection or an electrical connection; it may refer to a direct connection or an indirect connection through an intermediary; it may refer to the internal communication of two elements or the interaction relationship between two elements. For those of ordinary skill in the art, the specific meanings of the above terms in the present application can be understood based on specific circumstances.

With the rapid development of new energy technologies, the application of high-power electronic devices is becoming increasingly widespread. Taking high-voltage energy storage devices as an example, they typically include high-voltage converters and high-voltage energy storage valves. The high-voltage converter is configured to implement the conversion function between alternating current and direct current, while the high-voltage energy storage valve is configured to implement power output and energy storage functions. Therefore, the high-voltage converter is typically formed by connecting multiple power modules in series, with the power modules being relatively lightweight and compact, facilitating mounting and integration. This also makes the overall structure of the high-voltage converter relatively compact with a simple layout.

The high-voltage energy storage valve is configured to achieve power output and energy storage functions, and typically requires multiple energy storage valve modules connected in series. A single energy storage valve module consists of a power module, a bus cabinet, and multiple electrical cabinet units connected in parallel. Higher system voltage and capacity require a greater number of electrical cabinet units. In addition, to satisfy the above electrical connection structure, the energy storage valve module further includes a supporting frame, a water-cooling pipeline, a fluid circulation loop, a shielding component structure, and the like. As a result, the energy storage valve module has a large size and heavy weight, which in turn makes its transportation extremely inconvenient.

Based on the above considerations, to address the issue that the energy storage device is difficult to transport due to its heavy weight, an energy storage device is designed in which the electrical cabinet unit is mounted in the electrical cabinet frame while the power module and the bus module are mounted externally on the electrical cabinet frame via a power frame and a bus frame, respectively, so that the power module and the bus module can be separated from the electrical cabinet module. This allows the energy storage device to be transported after being separated, and the electrical cabinet module, power module, and bus module as separate modules are lighter in weight than the complete energy storage device, thereby effectively improving transportation convenience.

The energy storage device disclosed in the embodiments of the present application can be used, but is not limited to, in fixed or mobile energy stations, such as energy storage containers, energy storage valve towers, energy storage distribution cabinets, energy storage power stations, and battery swap stations. In some embodiments, the energy storage device may further include other functional compartments, such as a control compartment and a fire protection compartment, where the control compartment is configured to manage the battery to achieve energy storage and output.

The energy storage device provided in the embodiments of the present application is described below.

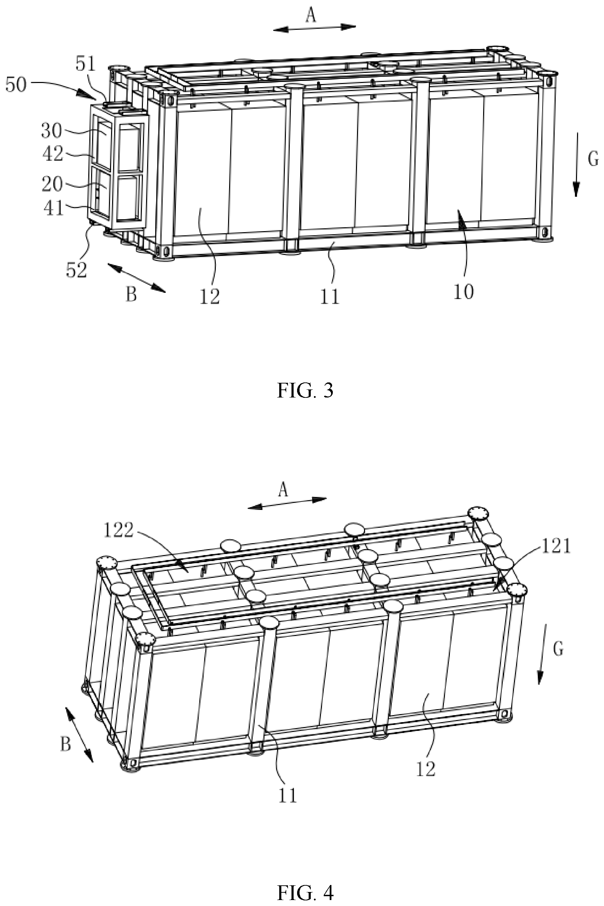

Referring to FIG. 3 and FIG. 4, in a first aspect, the embodiments of the present application provide an energy storage device 100, including an electrical cabinet module 10, a power module 20, and a bus module 30. The electrical cabinet module 10 includes an electrical cabinet frame 11 and an electrical cabinet unit 12 disposed within the electrical cabinet frame 11. The electrical cabinet unit 12 includes a cabinet structure (not shown in the drawings) and a battery (not shown in the drawings) disposed within the cabinet structure. The power module 20 and the bus module 30 are detachably connected to the electrical cabinet frame 11.

The electrical cabinet module 10 is a component configured to implement energy storage, the power module 20 is a component configured to implement power output, and the bus module 30 refers to a module component integrating components other than the electrical cabinet module 10 and the power module 20.

The electrical cabinet frame 11 is a frame structure configured to accommodate the electrical cabinet unit 12. Optionally, the electrical cabinet frame 11 may be constructed from multiple beam structures, for example, to form a rectangular frame, a spherical frame, a cylindrical frame, or the like. Alternatively, the electrical cabinet frame 11 may be a box-like structure composed of various structural members such as beam structures and panel structures.

Optionally, the number of electrical cabinet units 12 may be one or more. When there are multiple electrical cabinet units 12, they may be disposed within the electrical cabinet frame 11. For example, the electrical cabinet units 12 may be arranged sequentially in a single row or in multiple rows with intervals, or the electrical cabinet units 12 may be arranged in an array-like grid structure. The electrical cabinet unit 12 may be fixed to the electrical cabinet frame 11 by means of fasteners. The electrical cabinet unit 12 may include one or more (two or more) batteries. When there are multiple batteries, the batteries may be connected in series and/or parallel to form an integrated unit.

The power module 20 and the bus module 30 are detachably connected to the electrical cabinet frame 11 of the electrical cabinet module 10. Optionally, the power module 20 and the bus module 30 may be independently detachably connected to the electrical cabinet frame 11. The power module 20 and the bus module 30 may be mounted on a same end side of the electrical cabinet frame 11 or on different end sides; or the power module 20 and the bus module 30 may be mounted on the inner side of the electrical cabinet frame 11, or on the outer side of the electrical cabinet frame 11; or the power module 20 and the bus module 30 may first be connected as a whole and then detachably connected to the electrical cabinet frame 11 as a whole.

It can be understood that the power module 20 and the bus module 30 may be detachably connected to the electrical cabinet frame 11 in the following manners. The power module 20 and the bus module 30 are mounted on the surface of the electrical cabinet frame 11 by means of fasteners such as bolts or brackets, allowing the power module 20 and the bus module 30 to be removed or mounted by removing or fastening the fasteners. Alternatively, the power module 20 and the bus module 30 may be connected to the electrical cabinet frame 11 by means of clamping or snap-fitting connection, and removal may be achieved by separating the clamped or snap-fitted portions. Alternatively, a mounting structure such as a support plate or fixing bracket may be mounted on the surface of the electrical cabinet module 10, the power module 20 and the bus module 30 may be mounted on the support plate or fixing bracket by means of fasteners such as bolts, and the removal or mounting of the power module 20 and the bus module 30 relative to the support plate or fixing bracket thereby enables the power module 20 and the bus module 30 to be removed or mounted with respect to the electrical cabinet frame 11.

In the energy storage device 100 provided in the embodiments of the present application, the power module 20 and the bus module 30 are detachably connected to the electrical cabinet frame 11, which allows the power module 20 and the bus module 30 to be removed from the electrical cabinet frame 11 of the electrical cabinet module 10 when transportation is required, enabling separate packaging and transportation of the power module 20, bus module 30, and electrical cabinet module 10. As compared to integral transportation, the separated power module 20, bus module 30, and electrical cabinet module 10 are lighter in weight than the complete energy storage device 100 and can be transported separately, thereby effectively improving transportation convenience.

Referring to FIG. 3 and FIG. 4, in some embodiments, the power module 20 and the bus module 30 are detachably connected to an outer side of the electrical cabinet frame 11.

The power module 20 and the bus module 30 are detachably connected to the outer side of the electrical cabinet frame 11. Optionally, the power module 20 and the bus module 30 may be directly connected to the electrical cabinet frame 11 by means of fasteners, clamping, or snap-fitting methods and may be removed from the electrical cabinet frame 11. Alternatively, a frame structure may be used to accommodate the power module 20 and the bus module 30, and then the frame structure is detachably connected to the electrical cabinet frame 11. The frame structure may be an integral structural member in which both the power module 20 and the bus module 30 are accommodated, or may include two independent frames respectively accommodating the power module 20 and the bus module 30, which are then separately connected to the electrical cabinet frame 11. Alternatively, the power module 20 and the bus module 30 may be detachably connected to the electrical cabinet frame 11 by means of a connecting structure, for example, a hoop or a snap ring, and may be removed by opening the hoop or snap ring. Still alternatively, a mounting member (such as a mounting plate or bracket) may be used to support mounting of the power module 20 and the bus module 30, and the mounting member is detachably connected to the electrical cabinet frame 11, enabling detachable connection of the power module 20 and the bus module 30 relative to the electrical cabinet frame 11.

It can be understood that the sizes of the electrical cabinet unit 12, the power module 20, and the bus module 30 differ significantly, with the electrical cabinet unit 12 being relatively larger, while the power module 20 and the bus module 30 are relatively smaller. When the power module 20 and the bus module 30 are mounted inside the electrical cabinet frame 11 and arranged adjacent to the electrical cabinet unit 12, the electrical cabinet frame 11 needs to have a relatively large spatial volume since the electrical cabinet frame 11 is required to accommodate the relatively large-sized electrical cabinet unit 12. When the power module 20 and the bus module 30 are accommodated within the electrical cabinet frame 11, their space utilization is low, leading to wasted internal space in the electrical cabinet frame 11 and an overall larger volume of the electrical cabinet frame 11.

The electrical cabinet unit 12 is accommodated inside the electrical cabinet frame 11, and the power module 20 and the bus module 30 are externally mounted outside the electrical cabinet frame 11. In this mounting arrangement, the power module 20, bus module 30, and electrical cabinet unit 12, which differ significantly in size, can be disposed separately. The electrical cabinet frame 11 is used solely to accommodate the electrical cabinet unit 12, thereby achieving high space utilization within the electrical cabinet frame 11 and a more compact arrangement of the electrical cabinet units 12, effectively reducing the overall volume of the electrical cabinet frame 11. In addition, the power module 20 and the bus module 30 externally mounted outside the electrical cabinet frame 11 enhances the convenience of maintenance operations for the power module 20 and the bus module 30.

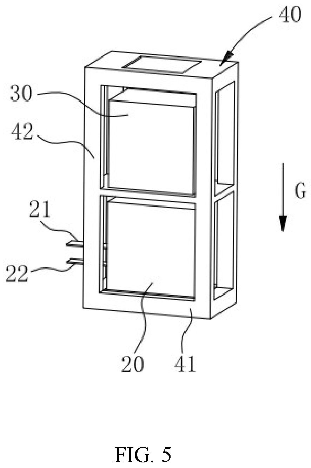

Referring to FIG. 3 to FIG. 5, in some embodiments, the energy storage device 100 further includes an external mounting frame 40, the external mounting frame 40 being detachably connected to the outer side of the electrical cabinet frame 11, with the power module 20 and the bus module 30 accommodated within the external mounting frame 40.

The external mounting frame 40 is configured to accommodate the power module 20 and the bus module 30. The external mounting frame 40 may be formed by one or a combination of beam structures, plate structures, or bracket structures. By way of example, the external mounting frame 40 may be a rectangular frame formed by combining beam structures, with the power module 20 and the bus module 30 disposed within the rectangular frame in a horizontal direction or the direction of gravity.

The external mounting frame 40 is detachably connected to the outer side of the electrical cabinet frame 11. Optionally, the external mounting frame 40 may be mounted on an outer side of the electrical cabinet frame 11 by means of fasteners such as bolts or screws, and may be removed by removing the bolts or screws. Alternatively, a connecting structure such as a connecting plate or bracket may be provided on the electrical cabinet frame 11, and the external mounting frame 40 may be mounted on the connecting structure such as the connecting plate or bracket to achieve mounting on the electrical cabinet frame 11.

With such an arrangement, the external mounting frame 40 is utilized to accommodate the power module 20 and the bus module 30, so that the power module 20 and the bus module 30 can be removed simultaneously by removing the external mounting frame 40 from the electrical cabinet frame 11, improving the removal and mounting efficiency while enhancing the regularity of the power module 20 and bus module 30 when assembled onto the electrical cabinet module 10.

Referring to FIG. 3 to FIG. 5, in some embodiments, the external mounting frame 40 includes a first frame portion 41 and a second frame portion 42 arranged along the direction of gravity, with the power module 20 accommodated in the first frame portion 41 and the bus module 30 accommodated in the second frame portion 42.

The first frame portion 41 and the second frame portion 42 are two parts of the external mounting frame 40. The external mounting frame 40 may be provided with mounting beams or plates to divide the external mounting frame 40 into upper and lower frame portions.

Optionally, the first frame portion 41 may be located below the second frame portion 42 in the direction of gravity, such that the power module 20 is located below the bus module 30; alternatively, the second frame portion 42 may be located below the first frame portion 41 in the direction of gravity, such that the bus module 30 is located below the power module 20.

In some specific implementations, the external mounting frame 40 is a rectangular frame formed by combining multiple module beams, with a mounting beam provided at the middle of the rectangular frame in the direction of gravity. The frame structure of the external mounting frame 40 above the mounting beam forms the second frame portion 42, and the frame structure of the external mounting frame 40 below the mounting beam forms the first frame portion 41, allowing the power module 20 to be accommodated in the lower first frame portion 41 and the bus module 30 to be accommodated in the upper second frame portion 42.

With such an arrangement, the power module 20 and the bus module 30 are accommodated in the first frame portion 41 and the second frame portion 42, respectively, enabling the power module 20 and the bus module 30 to be arranged sequentially along the direction of gravity, thereby facilitating separate maintenance operations for the power module 20 and the bus module 30.

Referring to FIG. 3 to FIG. 5, in some embodiments, the energy storage device 100 further includes a limiting apparatus 50, the limiting apparatus 50 being disposed on the electrical cabinet frame 11 and connected to the external mounting frame 40.

The limiting apparatus 50 is configured to support and limit the external mounting frame 40. The limiting apparatus 50 may serve to restrict and fix the external mounting frame 40 onto the electrical cabinet frame 11; or the limiting device 50 may define the mounting position of the external mounting frame 40, such that the mounting position of the external mounting frame 40 is limited, and then the external mounting frame 40 is connected to the electrical cabinet frame 11.

The limiting apparatus 50 is disposed on the electrical cabinet frame 11 and may be connected to the electrical cabinet frame 11 by means of fasteners (such as bolts or screws). Alternatively, the limiting member may be mounted onto the electrical cabinet frame 11 through an auxiliary structure (such as a connecting plate or L-shaped bracket).

Optionally, the limiting apparatus 50 includes, but is not limited to, a structure such as a limiting plate, limiting frame, limiting rod, or limiting frame. By way of example, in some implementations, the limiting apparatus 50 includes a limiting plate. The limiting plate may be mounted on the electrical cabinet frame 11, and the external mounting frame 40 may be placed on the limiting plate. The limiting plate is used to provide support and positional restriction for the external mounting frame 40 to achieve the purpose of restricting and fixing the external mounting frame 40 onto the electrical cabinet frame 11, effectively improving the convenience of installation operations.

With such an arrangement, the limiting apparatus 50 is utilized to support and position the external mounting frame 40, such that the external mounting frame 40 is not only connected to the electrical cabinet frame 11 but also supported and limited by the limiting apparatus 50, effectively improving the mounting stability of the external mounting frame 40.

Referring to FIG. 3 to FIG. 5, in some embodiments, the limiting apparatus 50 includes a top limiting structure 51 and a bottom limiting structure 52, both of which are connected to the electrical cabinet frame 11. In the direction of gravity, the top limiting structure 51 abuts against a top end of the external mounting frame 40, and the bottom limiting structure 52 abuts against a bottom end of the external mounting frame 40.

Optionally, the top limiting structure 51 includes, but is not limited to, a limiting bracket, a limiting block, a limiting plate, or a limiting rod, and is capable of connecting to the electrical cabinet frame 11. The top limiting structure 51 is also capable of connecting to the top of the external mounting frame 40 to achieve limiting connection for the external mounting frame 40. The bottom limiting structure 52 includes, but is not limited to, a limiting bracket, a limiting block, a limiting plate, a limiting rod, or a limiting slider, and is capable of connecting to the electrical cabinet frame 11. The bottom limiting structure 52 is also capable of connecting to the bottom of the external mounting frame 40 to limit and support the external mounting frame 40.

With such an arrangement, the top limiting structure 51 and the bottom limiting structure 52 are utilized to act together on the top and bottom ends of the external mounting frame 40, thereby supporting and limiting the external mounting frame 40 in the direction of gravity, effectively improving the mounting accuracy of the external mounting frame 40 and improving the stability of the external mounting frame 40 mounted.

By way of example, in some specific implementations, the top limiting structure 51 includes a limiting bracket, and the bottom limiting structure 52 includes a limiting support plate and a limiting slider, with the limiting slider slidably connected to the limiting support plate. During assembly, the limiting support plate is fixedly mounted on the electrical cabinet frame 11, and the external mounting frame 40 is mounted on the limiting slider. The limiting slider slides relative to the limiting support plate to move the external mounting frame 40 toward and abut against the electrical cabinet frame 11, and a locking member such as a bolt is utilized to lock the limiting slider and the limiting support plate together. In addition, the limiting bracket is fixed to the electrical cabinet frame 11 and is fixedly connected to the top of the external mounting frame 40. Thus, the limiting support plate and the limiting slider can support and lock the external mounting frame 40 in a position abutting the electrical cabinet frame 11, so as to mount the external mounting frame 40.

Referring to FIG. 3 to FIG. 5, in some embodiments, the electrical cabinet units 12 are sequentially arranged along a first direction A perpendicular to the direction of gravity G, and the external mounting frame 40 is disposed on any side of the electrical cabinet frame 11 in the first direction A.

It can be understood that the first direction A is perpendicular to the direction of gravity G. When the electrical cabinet frame 11 is a rectangular structural frame and is placed on a plane according to gravity, the first direction A may be the width direction or the length direction of the electrical cabinet frame 11 in the plane.

The electrical cabinet units 12 are sequentially disposed along the first direction A. Optionally, multiple electrical cabinet units 12 may be disposed to form a single-row electrical cabinet group or a double-row or multi-row electrical cabinet group. Cabinet doors of the electrical cabinet units 12 may be disposed along a direction perpendicular to the first direction A, such that the cabinet doors of the sequentially arranged electrical cabinet units 12 face outward from the electrical cabinet frame 11, facilitating operations by personnel.

With such an arrangement, the electrical cabinet units 12 may be sequentially disposed within the electrical cabinet frame 11 along the first direction A, with the external mounting frame 40 disposed on any side of the electrical cabinet frame 11 in the first direction A, so that the external mounting frame 40 does not obstruct or interfere with the electrical cabinet units 12 in the direction perpendicular to the first direction A, facilitating operations on the electrical cabinet units 12.

Referring to FIG. 3 to FIG. 5, in some embodiments, the electrical cabinet units 12 are arranged along the first direction A to form a first electrical cabinet group 121 and a second electrical cabinet group 122, and the first electrical cabinet group 121 and the second electrical cabinet group 122 are arranged along a second direction B to form two rows, with cabinet doors of the first electrical cabinet group 121 and the second electrical cabinet group 122 arranged back-to-back; where the second direction B is perpendicular to both the direction of gravity G and the first direction A.

The second direction B is perpendicular to both the direction of gravity G and the first direction A, such that the first direction A, the second direction B, and the direction of gravity G are mutually perpendicular. It can be understood that, as a three-dimensional structure, the electrical cabinet frame 11 has width, thickness, and height parameters. In some implementations, the direction of gravity G corresponds to the height direction of the electrical cabinet frame 11, the first direction A may correspond to the width direction of the electrical cabinet frame 11, and thus the second direction B corresponds to the thickness direction of the electrical cabinet frame 11.

The first electrical cabinet group 121 is formed by arranging multiple electrical cabinet units 12 along the first direction A, for example, consisting of one, two, or more electrical cabinet units 12. Similarly, the second electrical cabinet group 122 is also formed by arranging one, two, or more electrical cabinet units 12. The first electrical cabinet group 121 and the second electrical cabinet group 122 are arranged in two rows along the second direction B, and the number of electrical cabinet units 12 in the first electrical cabinet group 121 and the second electrical cabinet group 122 may be the same or different.

By way of example, in some implementations, the number of electrical cabinet units 12 in the first electrical cabinet group 121 is consistent with that in the second electrical cabinet group 122, such that the electrical cabinet units 12 in the first electrical cabinet group 121 and the second electrical cabinet group 122 can be placed back-to-back in pairs, with the backs of two electrical cabinet units 12 close to each other and their front ends (that is, cabinet door ends or operation ends) facing away from each other. This allows the cabinet doors of the electrical cabinet units 12 in the first electrical cabinet group 121 and the second electrical cabinet group 122 to face outward from the electrical cabinet frame 11, effectively improving the convenience of maintenance for the electrical cabinet units 12.

With such an arrangement, the electrical cabinet units 12 are arranged along the first direction A to form the first electrical cabinet group 121 and the second electrical cabinet group 122, with the cabinet doors of the first electrical cabinet group 121 and the second electrical cabinet group 122 arranged back-to-back, thereby increasing the energy density of the energy storage device 100 and allowing operations and maintenance to be performed facing the cabinet doors of the first electrical cabinet group 121 and the cabinet doors of the second electrical cabinet group 122 outside the electrical cabinet frame 11, effectively improving operational convenience.

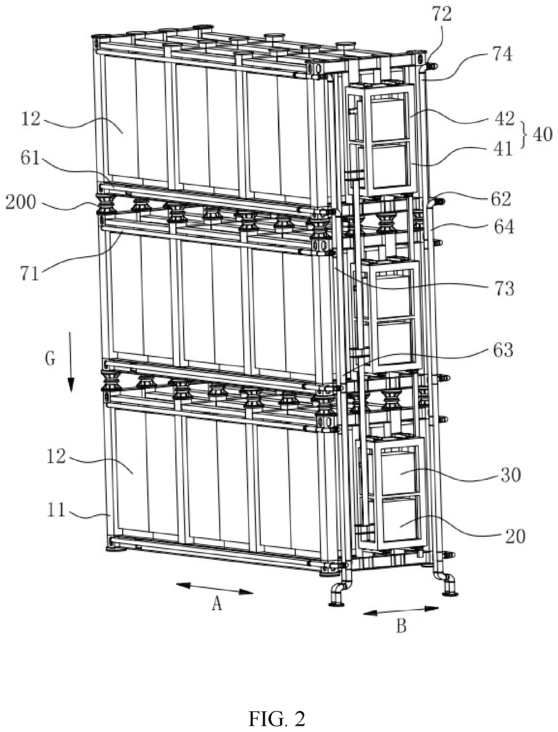

Referring to FIG. 2 to FIG. 5, in some embodiments, the energy storage device 100 includes a first inlet pipe 61, a first outlet pipe 71, a second inlet pipe 62, and a second outlet pipe 72. The first inlet pipe 61 and the first outlet pipe 71 are both in communication with the first electrical cabinet group 121 and disposed along the first direction A; and the second inlet pipe 62 and the second outlet pipe 72 are both in communication with the second electrical cabinet group 122 and disposed along the first direction A.

The first inlet pipe 61 and the first outlet pipe 71 are pipeline structures for circulating the cooling medium. The first inlet pipe 61 is connected to the first electrical cabinet group 121, that is, connected to electrical cabinet units 12 in the first electrical cabinet group 121, allowing the cooling medium to be introduced from the first inlet pipe 61 into the electrical cabinet units 12 in the first electrical cabinet group 121 to cool interiors of the electrical cabinet units 12. In addition, the first outlet pipe 71 is also in communication with the electrical cabinet units 12 in the first electrical cabinet group 121, allowing the cooling medium, after cooling the electrical cabinet units 12 in the first electrical cabinet group 121, to be discharged through the first outlet pipe 71, forming a circulating path for the cooling medium.

Similarly, the second inlet pipe 62 and the second outlet pipe 72 are pipeline structures for circulating the cooling medium, configured to circulate the cooling medium within the second electrical cabinet group 122 to cool electrical cabinet units 12 in the second electrical cabinet group 122.

It should be understood that a cooling structure, for example a cooling member such as a water-cooling plate or pipe, is generally provided inside the first electrical cabinet group 121 and the second electrical cabinet group 122. Optionally, the cooling structure may be integrally provided within the first electrical cabinet group 121 and the second electrical cabinet group 122 to simultaneously cool the electrical cabinet units 12 in the respective group; alternatively, each electrical cabinet unit 12 in the first electrical cabinet group 121 and the second electrical cabinet group 122 may be provided with an independent cooling structure to individually cool each electrical cabinet unit 12.

The cooling medium includes, but is not limited to, cooling liquids with high specific heat capacity, such as cooling water or cooling oil.

The first inlet pipe 61 and the first outlet pipe 71 are both disposed along the first direction A, where the electrical cabinet units 12 in the first electrical cabinet group 121 are also arranged along the first direction A, meaning the layout direction of the first inlet pipe 61 and the first outlet pipe 71 is consistent with the arrangement direction of the electrical cabinet units 12 in the first electrical cabinet group 121. This allows the first inlet pipe 61 and the first outlet pipe 71 to pass alongside the respective electrical cabinet units 12 in the first electrical cabinet group 121, facilitating the connection of the electrical cabinet units 12 in the first electrical cabinet group 121 to the first inlet pipe 61 and the first outlet pipe 71, with shorter connection paths. Thus, the connection path from the electrical cabinet units 12 in the first electrical cabinet group 121 to the first inlet pipe 61 and the first outlet pipe 71 can be effectively shortened, improving the compactness of the arrangement of the first inlet pipe 61 and the first outlet pipe 71 relative to the first electrical cabinet group 121.

Similarly, the second inlet pipe 62 and the second outlet pipe 72 are both disposed along the first direction A, and the electrical cabinet units 12 in the second electrical cabinet group 122 are also arranged along the first direction A, effectively shortening the connection path from the electrical cabinet units 12 in the second electrical cabinet group 122 to the second inlet pipe 62 and the second outlet pipe 72, improving the compactness of the arrangement of the second inlet pipe 62 and the second outlet pipe 72 relative to the second electrical cabinet group 122. This enhances the overall space utilization of the energy storage device 100, and reduces the spatial footprint of the energy storage device 100.

Optionally, the first inlet pipe 61 may be disposed above the first outlet pipe 71 in the direction of gravity G, allowing the cooling medium to be introduced into the first electrical cabinet group 121 in a top-in and bottom-out manner; alternatively, the first inlet pipe 61 may be disposed below the first outlet pipe 71 in the direction of gravity G, allowing the cooling medium to be introduced into the first electrical cabinet group 121 in a bottom-in and top-out manner. Similarly, the second inlet pipe 62 and the second outlet pipe 72 may also be disposed sequentially in the height direction to circulate the cooling medium through the second electrical cabinet group 122 in a top-in and bottom-out or bottom-in and top-out manner.

Referring to FIG. 2 to FIG. 5, in some embodiments, the energy storage device 100 further includes a third inlet pipe 63 and a third outlet pipe 73. The first inlet pipe 61 is connected to the third inlet pipe 63, and the first outlet pipe 71 is connected to the third outlet pipe 73; the third inlet pipe 63 and the third outlet pipe 73 are arranged on a side of the external mounting frame 40 that is in the second direction B and faces the first electrical cabinet group 121, and the third inlet pipe 63 and the third outlet pipe 73 are located between the external mounting frame 40 and the electrical cabinet frame 11.

The third inlet pipe 63 and the third outlet pipe 73 are pipeline structures for circulating the cooling medium. The third inlet pipe 63 and the third outlet pipe 73 may serve as main pipelines for circulating the cooling medium, with the cooling medium introduced from the third inlet pipe 63 into the first inlet pipe 61 and then into the first electrical cabinet group 121, while the cooling medium is discharged from the first electrical cabinet group 121 to the first outlet pipe 71 and then into the third outlet pipe 73 for discharge.

It can be understood that the external mounting frame 40 is disposed on a side of the electrical cabinet frame 11 in the first direction A, so the opposite sides of the external mounting frame 40 in the second direction B and the side of the electrical cabinet frame 11 facing the external mounting frame 40 form a recessed region. Thus, the region between the external mounting frame 40 and the electrical cabinet frame 11 in the second direction B refers to a range that does not exceed the opposite sides of the external mounting frame 40 in the second direction B along the first direction A and does not exceed the side of the electrical cabinet frame 11 facing the external mounting frame 40 along the second direction B.

The third inlet pipe 63 and the third outlet pipe 73 are arranged between the external mounting frame 40 and the electrical cabinet frame 11, on the side of the external mounting frame 40 that is in the second direction B and faces the first electrical cabinet group 121, and the first inlet pipe 61 and the first outlet pipe 71 are respectively connected to the third inlet pipe 63 and the third outlet pipe 73.

Further, the energy storage device 100 includes a fourth inlet pipe 64 and a fourth outlet pipe 74. The second inlet pipe 62 is connected to the fourth inlet pipe 64, and the second outlet pipe 72 is connected to the fourth outlet pipe 74. The fourth inlet pipe 64 and the fourth outlet pipe 74 are disposed on a side of the external mounting frame 40 that is in the second direction B and faces the second electrical cabinet group 122, and the fourth inlet pipe 64 and the fourth outlet pipe 74 are located between the external mounting frame 40 and the electrical cabinet frame 11.

The fourth inlet pipe 64 and the fourth outlet pipe 74 are pipeline structures for circulating the cooling medium. The fourth inlet pipe 64 and the fourth outlet pipe 74 may serve as main pipelines for circulating the cooling medium, with the cooling medium introduced from the fourth inlet pipe 64 into the second inlet pipe 62 and then into the second electrical cabinet group 122, while the cooling medium is discharged from the second electrical cabinet group 122 to the second outlet pipe 72 and then into the fourth outlet pipe 74 for discharge.

The fourth inlet pipe 64 and the fourth outlet pipe 74 are disposed between the external mounting frame 40 and the electrical cabinet frame 11, on a side of the external mounting frame 40 that is in the second direction B and faces the second electrical cabinet group 122, and the second inlet pipe 62 and the second outlet pipe 72 are respectively connected to the fourth inlet pipe 64 and the fourth outlet pipe 74.

With such an arrangement, the third inlet pipe 63 and the third outlet pipe 73 are disposed between a side of the external mounting frame 40 in the second direction B and the electrical cabinet frame 11, and the fourth inlet pipe 64 and the fourth outlet pipe 74 are disposed between the other side of the external mounting frame 40 in the second direction B and the electrical cabinet frame 11. Such an arrangement can effectively improve the pipeline layout, reduce the spatial occupation of the third inlet pipe 63 and the third outlet pipe 73, further enhance the compactness of the energy storage device 100, and improve the space utilization of the energy storage device 100.

Referring to FIG. 2 to FIG. 5, in some embodiments, the third inlet pipe 63 and the third outlet pipe 73 are both in communication with the power module 20.

It can be understood that the third inlet pipe 63 and the third outlet pipe 73 are in communication with the power module 20, allowing the cooling medium to be introduced from the third inlet pipe 63 into the interior of the power module 20 and discharged by the third outlet pipe 73 from the power module 20, forming a circulating path for the cooling medium.

It should be understood that a cooling structure such as a water-cooling plate or pipe is generally provided inside the power module 20. Taking a water-cooling plate as an example, a cooling medium is introduced into the water-cooling plate through the third inlet pipe 63 and discharged from the water-cooling plate through the third outlet pipe 73, enabling the cooling medium within the water-cooling plate to exchange heat with and cool the interior of the power module 20.

In other implementations, the fourth inlet pipe 64 and the fourth outlet pipe 74 may also be connected to the power module 20 to enable cooling of the interior of the power module 20.

With such an arrangement, since the third inlet pipe 63 and the third outlet pipe 73 are disposed between the external mounting frame 40 and the electrical cabinet frame 11, they are closer to the power module 20, and the connection path from the power module 20 to the third inlet pipe 63 and the third outlet pipe 73 is shorter, further improving the space utilization of the energy storage device 100.

Referring to FIG. 2 to FIG. 5, in some embodiments, the power module 20 is provided with an inlet busbar 21 and an outlet busbar 22, the inlet busbar 21 and the outlet busbar 22 being disposed on any side of the external mounting frame 40 in the second direction B and located between the external mounting frame 40 and the electrical cabinet frame 11.

The inlet busbar 21 and the outlet busbar 22 refer to conductive structures, such as conductive copper bars, used by the power module 20 for electrical connection with external components. The inlet busbar 21 and the outlet busbar 22 may be connected in series via an external busbar assembly to achieve electrical conduction.

With such an arrangement, the inlet busbar 21 and the outlet busbar 22 are disposed between the external mounting frame 40 and the electrical cabinet frame 11, so that in connecting to the inlet busbar 21 and the outlet busbar 22, a wiring busbar is to be routed between the external mounting frame 40 and the electrical cabinet frame 11, thereby improving the compactness of the wiring layout and enhancing the space utilization of the energy storage device 100.

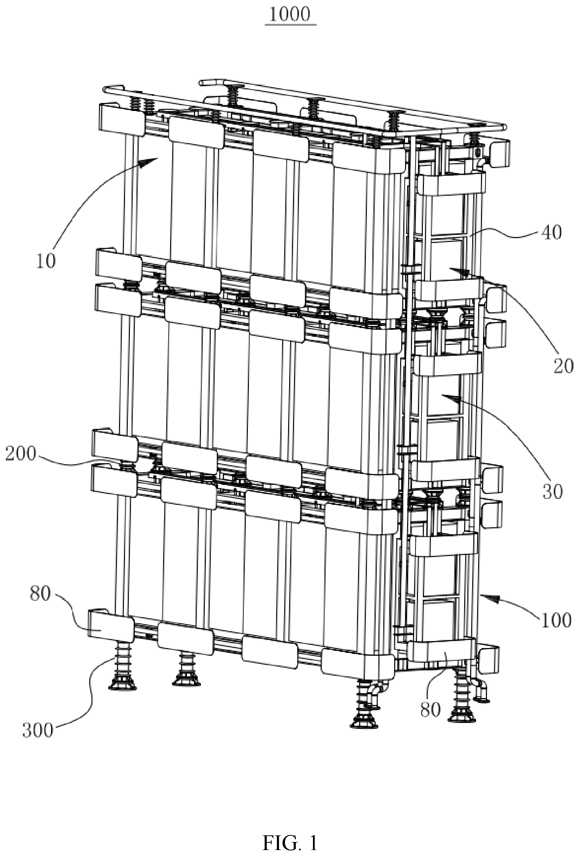

Referring to FIG. 1 to FIG. 3, in some embodiments, the energy storage device further includes a shielding cover 80, the shielding cover 80 being disposed on the electrical cabinet frame 11 and the external mounting frame 40, and configured to cover at least part of the electrical cabinet frame 11 and at least part of the external mounting frame 40.

The shielding cover 80 is configured to provide equipotential protection for the electrical cabinet frame 11 and the external mounting frame 40. The shielding cover 80 may be made of metal materials. For example, the shielding cover 80 may be, but is not limited to, a copper, aluminum, or steel cover that forms an equipotential protection structure.

Optionally, the shielding cover 80 may cover and protect all exposed parts of the electrical cabinet frame 11 and the external mounting frame 40; alternatively, the shielding cover 80 may cover and protect only the tip portions of the electrical cabinet frame 11 and the external mounting frame 40 to reduce the likelihood of tip discharge.

In some implementations, both the electrical cabinet frame 11 and the external mounting frame 40 are formed by assembling beam structures. At the intersections of two or more beams, resulting joints may form ends with tip structures. The shielding cover 80 can be mounted on these ends with tip structures, as shown in FIG. 1, so as to prevent tip discharge.

By way of example, in some specific implementations, the energy storage device 100 includes a power module 20, a bus module 30, and an electrical cabinet module 10. The electrical cabinet module 10 includes an electrical cabinet frame 11 and electrical cabinet units 12 accommodated within the electrical cabinet frame 11. The electrical cabinet units 12 are arranged along the first direction A to form a first electrical cabinet group 121 and a second electrical cabinet group 122, which are sequentially arranged in the second direction B and placed back-to-back. The power module 20 and the bus module 30 are both accommodated within the external mounting frame 40, distributed on the upper and lower sides of the external mounting frame 40 along the direction of gravity G. The external mounting frame 40 is mounted on the electrical cabinet frame 11 via a limiting apparatus 50 to achieve external mounting of the power module 20 and the bus module 30 on the electrical cabinet module 10. When transportation is required, the external mounting frame 40 may be separated from the electrical cabinet frame 11, allowing the electrical cabinet frame 11 and its internal electrical cabinet units 12 to be packaged for transportation, and the external mounting frame 40 and its internal power module 20 and bus module 30 to be packaged separately for transportation. This separation of the entire energy storage device 100 into two parts for transportation effectively improves transportation convenience.

Referring to FIG. 1 to FIG. 5, in a second aspect, embodiments of the present application further provide an energy storage valve tower 1000, including the energy storage device 100 as described above.

The energy storage valve tower 1000 provided in the embodiments of the present application includes the above-described energy storage device 100, making the transportation and assembly operations of the energy storage valve tower 1000 more convenient due to the enhanced transportability of the energy storage device 100.

Referring to FIG. 1 to FIG. 5, in some embodiments, the energy storage devices 100 are stacked along the direction of gravity G.

It can be understood that the energy storage valve tower 1000 may include one energy storage device 100, or two or more energy storage devices 100. Taking three energy storage devices 100 as an example, the three energy storage devices 100 may be stacked sequentially upward along the direction of gravity G, effectively reducing the footprint of the energy storage valve tower 1000.

When multiple energy storage devices 100 are stacked along the direction of gravity G for assembly, the third inlet pipes 63 of each energy storage device 100 are interconnected, and similarly, the third outlet pipes 73, the fourth inlet pipes 64, and the fourth outlet pipes 74 of each energy storage device 100 are correspondingly interconnected, so that the third inlet pipe 63, the third outlet pipe 73, the fourth inlet pipe 64, and the fourth outlet pipe 74 together form main pipelines for circulating the cooling medium throughout the energy storage valve tower 1000.

Similarly, when multiple energy storage devices 100 are stacked along the direction of gravity G and assembled, the inlet busbars 21 and outlet busbars 22 provided on the power module 20 of each energy storage device 100 are located on a same side and can be sequentially connected in series via positive and negative busbars of a busbar assembly to form a series connection. The positive and negative busbars of the busbar assembly are routed along the direction of gravity G and located between the external mounting frame 40 and the electrical cabinet frame 11, improving the spatial layout rationality of the routing and reducing spatial occupation.

Optionally, an insulation structure 200 may be utilized to separate two adjacent energy storage devices 100, for example, an insulator may be placed between the two energy storage devices 100. Further, an insulation base 300 may be used, with the energy storage devices 100 stacked on the insulation base 300 to further enhance the insulation effect of the energy storage valve tower 1000.

With such an arrangement, the energy storage devices 100 are stacked along the direction of gravity G, which can effectively reduce the footprint of the energy storage valve tower 1000, and the stacked energy storage devices 100 can be separated to facilitate transportation.

The above are only preferred embodiments of the present application and are not intended to limit the present application. Any modifications, equivalent replacements, improvements, or the like made within the spirit and principles of the present application should be included within the scope of protection of the present application.

## Claims

1. An energy storage device, comprising an electrical cabinet module, a power module, and a bus module, wherein the electrical cabinet module comprises an electrical cabinet frame and an electrical cabinet unit disposed within the electrical cabinet frame; the electrical cabinet unit comprises a cabinet structure and a battery disposed within the cabinet structure, and the power module and the bus module are detachably connected to the electrical cabinet frame.

2. The energy storage device according to claim 1, wherein the power module and the bus module are detachably connected to an outer side of the electrical cabinet frame.

3. The energy storage device according to claim 2, further comprising an external mounting frame, the external mounting frame being detachably connected to an outer side of the electrical cabinet frame, with the power module and the bus module accommodated within the external mounting frame.

4. The energy storage device according to claim 3, wherein the external mounting frame comprises a first frame portion and a second frame portion arranged along the direction of gravity, with the power module accommodated in the first frame portion and the bus module accommodated in the second frame portion.

5. The energy storage device according to claim 4, further comprising a limiting apparatus, the limiting apparatus being disposed on the electrical cabinet frame and connected to the external mounting frame.

6. The energy storage device according to claim 5, wherein the limiting apparatus comprises a top limiting structure and a bottom limiting structure, both connected to the electrical cabinet frame; in the direction of gravity, the top limiting structure abuts against a top end of the external mounting frame, and the bottom limiting structure abuts against a bottom end of the external mounting frame.

7. The energy storage device according to any one of claims 3 to 6, wherein the electrical cabinet units are sequentially disposed along a first direction perpendicular to the direction of gravity, and the external mounting frame is disposed on any side of the electrical cabinet frame in the first direction.

8. The energy storage device according to claim 7, wherein the electrical cabinet units are arranged along the first direction to form a first electrical cabinet group and a second electrical cabinet group, and the first electrical cabinet group and the second electrical cabinet group are arranged along a second direction to form two rows, with cabinet doors of the first electrical cabinet group and the second electrical cabinet group arranged back-to-back; wherein the second direction is perpendicular to both the direction of gravity and the first direction.

9. The energy storage device according to claim 8, wherein the energy storage device comprises a first inlet pipe, a first outlet pipe, a second inlet pipe, and a second outlet pipe; the first inlet pipe and the first outlet pipe are both in communication with the first electrical cabinet group and disposed along the first direction; and the second inlet pipe and the second outlet pipe are both in communication with the second electrical cabinet group and disposed along the first direction.

10. The energy storage device according to claim 9, wherein the energy storage device further comprises a third inlet pipe, a third outlet pipe, a fourth inlet pipe, and a fourth outlet pipe;
the first inlet pipe is connected to the third inlet pipe, the first outlet pipe is connected to the third outlet pipe, the third inlet pipe and the third outlet pipe are disposed on a side of the external mounting frame that is in the second direction and faces the first electrical cabinet group, and the third inlet pipe and the third outlet pipe are located between the external mounting frame and the electrical cabinet frame; and
the second inlet pipe is connected to the fourth inlet pipe, the second outlet pipe is connected to the fourth outlet pipe, the fourth inlet pipe and the fourth outlet pipe are disposed on a side of the external mounting frame that is in the second direction and faces the second electrical cabinet group, and the fourth inlet pipe and the fourth outlet pipe are located between the external mounting frame and the electrical cabinet frame.

11. The energy storage device according to claim 10, wherein the third inlet pipe and the third outlet pipe are both in communication with the power module.

12. The energy storage device according to claim 11, wherein the power module is provided with an inlet busbar and an outlet busbar, the inlet busbar and the outlet busbar being disposed on any side of the external mounting frame in the second direction and located between the external mounting frame and the electrical cabinet frame.

13. The energy storage device according to any one of claims 3 to 12, further comprising a shielding cover, the shielding cover being disposed on the electrical cabinet frame and the external mounting frame, and configured to cover at least part of the electrical cabinet frame and at least part of the external mounting frame.

14. An energy storage valve tower, comprising the energy storage device according to any one of claims 1 to 13.

15. The energy storage valve tower according to claim 14, wherein the energy storage devices are stacked along the direction of gravity.
